# DEMANDE DE BREVET EUROPEEN

(11) **EP 4 455 799 A1**
(43) Date de publication de la demande: **30.10.2024**
(21) Numéro de dépôt: 23170406.5
(22) Date de dépôt: 27.04.2023
(51) Int. Cl.: G04B 37/22, A44C 27/00, C23C 14/06, G04B 45/00, G04D 3/00

(54) **PIÈCE D'HABILLAGE D'HORLOGERIE OU DE BIJOUTERIE COMPRENANT UN REVÊTEMENT DE COULEUR INTRINSÈQUE SATURÉE ET PROCÉDÉ DE FABRICATION DE LADITE PIÈCE D'HABILLAGE**

(71) Demandeur: The Swatch Group Research and Development Ltd, 2074 Marin (CH)
(72) Inventeur: FORNABAIO, Marta, 1023 Crissier (CH); TABARD, Lucie, 2000 Neuchâtel (CH); SPASSOV, Vladislav, 1788 Praz (CH); CURCHOD, Loïc, 1004 Lausanne (CH)
(74) Mandataire: ICB SA

(57) **Abrégé**

L'invention concerne une pièce d'habillage (10) d'horlogerie ou de bijouterie caractérisée en ce qu'elle comprend un substrat (11) sur une surface duquel s'étend un revêtement (12) comprenant un nitrure ou oxynitrure à base de tantale Ta présentant une épaisseur comprise entre 300 nm et 10 µm et une couleur intrinsèque et saturée.

## Description

### Domaine technique de l'invention

L'invention relève du domaine de l'horlogerie ou de la bijouterie, et concerne plus particulièrement une pièce d'habillage d'horlogerie ou de bijouterie comprenant un revêtement de couleur intrinsèque, et un procédé de fabrication de ladite pièce d'habillage.

On désigne dans le présent texte par « pièce d'habillage », tout article décoratif dans les domaines de l'horlogerie ou de la bijouterie, par exemple constitué par un boitier, un cadran, une applique de cadran, une aiguille, une lunette, une couronne, des maillons de bracelets, etc. destinés à être visibles pour un utilisateur.

Préférentiellement, la présente invention concerne une pièce d'habillage d'horlogerie ou de bijouterie comprenant un revêtement dont la couleur intrinsèque est une nuance de rouge.

### Arrière-plan technologique

Dans le domaine de l'horlogerie ou de la bijouterie, et plus généralement dans celui des articles décoratifs, les procédés de dépôts par peinture, vernissage ou émaillage ne sont pas toujours adaptés.

En effet, d'une part, la couche de matière appliquée à la surface d'un article à décorer est trop épaisse pour laisser apparaitre d'éventuelles structurations de surface, par exemple une surface brossée, soleillée, sablée, structurée laser, etc., et d'autre part, la durée de vie de cette couche et par conséquent de sa couleur n'est pas toujours satisfaisante.

Ainsi, les techniques de dépôt de couche mince sous vide, tels que les procédés de dépôt physique en phase vapeur (connu sous l'acronyme en langue anglaise « PVD » pour « Physical Vapor Déposition »), les procédés de dépôt chimique en phase vapeur (connu sous l'acronyme en langue anglaise « CVD » pour « Chemical Vapor Déposition »), les procédés de dépôt de couche atomique (connu sous l'acronyme en langue anglaise « ALD » pour « Atomic Layer Déposition »), sont préférées. En effet, ces techniques de dépôt de couche mince sous vide permettent de déposer des couches fines et résistantes, typiquement adaptées pour revêtir des pièces de petites dimensions, sujettes aux frottements et comprenant par exemple une structuration de surface fine.

Toutefois, malgré le fait que ces techniques de dépôt permettent d'obtenir des revêtements d'une multitude de couleurs intrinsèques, la mise en oeuvre de ces procédés ne permet pas d'obtenir de manière industrielle certaines couleurs intrinsèques spécifiques, telles que les nuances de rouge, en particulier un rouge vif et éclatant.

Il est également connu de déposer un empilement de couches minces pour créer un système optique interférentiel permettant de générer une couleur donnée. Cependant, la perception de la couleur est susceptible de dépendre de l'angle de vue. Par ailleurs, l'empilement de couches minces présente des contraintes de fabrication importantes dans la mesure où la couleur générée dépend fortement de l'épaisseur des couches minces.

Il existe donc un besoin pour obtenir une pièce d'habillage présentant une couleur éclatante et saturée, par exemple rouge, obtenue par une ou plusieurs couches minces pour conserver la structure du substrat, dont l'aspect n'est pas variable avec l'angle de vue d'un utilisateur, et adaptée à être sollicitée mécaniquement sans se dégrader.

### Résumé de l'invention

À cet effet, la présente invention concerne une pièce d'habillage d'horlogerie ou de bijouterie comprenant un substrat sur une surface duquel s'étend un revêtement comprenant un nitrure ou oxynitrure métallique à base de tantale Ta dont l'épaisseur est comprise entre 300 nm et 10 µm de sorte à présenter une couleur prédéterminée.

Dans des modes particuliers de réalisation, l'invention peut comporter en outre l'une ou plusieurs des caractéristiques suivantes, prises isolément ou selon toutes les combinaisons techniquement possibles.

Dans des modes particuliers de réalisation, le revêtement présente une épaisseur comprise entre 1 µm et 3 µm, préférentiellement égale à 2 µm.

Dans des modes particuliers de réalisation, un revêtement rouge est réalisé en nitrure de tantale Ta avec une stoechiométrie sensiblement proche de ou égale à TasNs, de sorte à présenter une couleur rouge vif.

Dans des modes particuliers de réalisation, le revêtement est réalisé avec un rajout d'oxygène dans la gamme de 0-5% atomiques.

Dans des modes particuliers de réalisation, le revêtement présente une couleur rouge caractérisée par des coordonnées a* et b* supérieures à 20, préférentiellement supérieures à 50, encore plus préférentiellement par les coordonnées L* = [30 ; 50], a* = [50 ; 70] et b* = [60 ; 80], et en particulier, L* = 42, a* = 58 et b* = 72, dans l'espace colorimétrique CieLAB en mode transmission de l'illuminant normalisé D65, avec un observateur de 10° et une géométrie de mesure d:0°.

Dans des modes particuliers de réalisation, le revêtement forme une composition de type AB(O,N), avec B étant du tantale Ta et A un élément métallique.

Dans des modes particuliers de réalisation, l'élément métallique A est choisi de préférence parmi Ba, Ca, Nd, La, Sr, Eu, Yb. Le revêtement comprend alors une composition sensiblement proche de ou égale à respectivement BaTaO₂N, CaTaO₂N, NdTaO₂N, LaTaO₂N, SrTaO₂N, EuTaO₂N ou Yb₂Ta₂O₅N₂.

Selon un autre objet, la présente invention concerne un procédé de fabrication d'une pièce d'habillage d'horlogerie ou de bijouterie, par exemple telle que décrite précédemment, comprenant les étapes de :
- dépôt d'une couche mince d'un oxyde métallique à base de tantale Ta sur un substrat, ladite couche mince étant d'une épaisseur comprise entre 300 nm et 10 µm ;
- nitruration de la couche mince de sorte à former un revêtement comprenant au moins un nitrure ou oxynitrure métallique.

Dans des modes particuliers de mise en oeuvre, l'étape de nitruration de la couche déposée n'est pas complète afin de générer un oxynitrure du matériau du revêtement.

Dans des modes particuliers de mise en oeuvre, lors de l'étape de dépôt, la couche mince déposée est en TaOₓ et l'étape de nitruration est réalisée de sorte que le revêtement soit en nitrure de tantale Ta avec stoechiométrie sensiblement proche de ou égale à Ta₃N₅ orthorhombique, de sorte que le revêtement présente une couleur rouge.

Dans des modes particuliers de mise en oeuvre, lors de l'étape de dépôt, la couche mince déposée est en TaOₓ et est combinée avec au moins un élément métallique choisi parmi Ba, Ca, Nd, La, Sr, Eu ou Yb.

Dans des modes particuliers de mise en oeuvre, l'étape de nitruration est réalisée sous une atmosphère appropriée à une température comprise entre 600°C et 1200°C durant 10h à 60h, préférentiellement entre 700°C et 1000°C durant 20h à 50h.

Dans des modes particuliers de mise en oeuvre, l'étape de nitruration est réalisée sous une atmosphère appropriée à une température de 900°C durant 40h.

### Brève description des figures

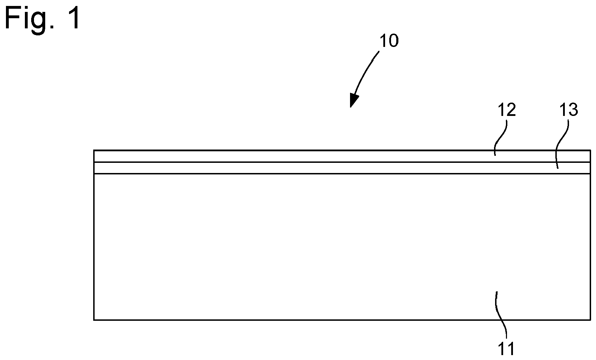

D'autres caractéristiques et avantages de l'invention apparaîtront à la lecture de la description détaillée suivante donnée à titre d'exemple nullement limitatif, en référence à la figure 1 annexée représentant schématiquement une vue en coupe d'une pièce d'habillage selon un exemple préféré de réalisation de l'invention.

On note que la figure n'est pas nécessairement dessinée à l'échelle pour des raisons de clarté.

### Description détaillée de l'invention

La présente invention concerne une pièce d'habillage 10 d'horlogerie ou de bijouterie, telle que visible schématiquement sur la figure 1, comprenant un substrat 11 sur une surface visible duquel s'étend un revêtement 12 comprenant un nitrure ou oxynitrure métallique. Le revêtement 12 présente une couleur prédéfinie en fonction du métal constituant le revêtement 12 tel que décrit plus loin dans le texte.

Le revêtement 12 présente une épaisseur suffisamment importante pour que sa couleur soit saturée, tout en étant suffisamment faible notamment pour ne pas gommer les éventuelles structurations de la surface du substrat 11 et pour ne pas impacter la conformité de la pièce d'habillage 10. L'épaisseur du revêtement 12 est, à cet effet, compris entre 300 nm et 10 µm, préférentiellement entre 1 µm et 3 µm. Encore plus préférentiellement, l'épaisseur du revêtement 12 est de 2 µm.

Le matériau constituant le substrat 11 est avantageusement choisi de sorte qu'il supporte les conditions de la déposition d'une couche d'oxyde métallique et la nitruration de ladite couche, tel que décrit plus en détail dans la suite du texte.

A titre d'exemple, le substrat 11 peut être réalisé en matériau céramique, par exemple en zircone ou en saphir, en alliage métallique, par exemple en acier inoxydable, ou peut être réalisé en silicium.

Avantageusement, la pièce d'habillage 10 peut comporter une couche d'accroche 13 réalisée en Ti, Cr ou autre métal approprié connu de l'homme de métier, interposée entre le substrat 11 et le revêtement 12. La couche d'accroche 13 présente une épaisseur comprise entre 20 nm et 500 nm, et préférentiellement égale à 100 nm.

Dans l'exemple préféré de réalisation de l'invention, le revêtement 12 est réalisé en nitrure de tantale, chimiquement et structurellement sensiblement proche de ou égale à Ta₃N₅ orthorhombique. Ce nitrure métallique présente une couleur rouge vif, c'est-à-dire saturée, définie par les coordonnées ci-dessous dans l'espace colorimétrique CieLAB, en mode réflexion de l'illuminant normalisé D65, avec observateur à 10°, en réflexion spéculaire incluse (SCI, géométrie de mesure di:8°) et exclue (SCE, géométrie de mesure de:8°).

| Matériau du substrat | SCI/SCE | L* | a* | b* |
|---|---|---|---|---|
| Saphir | SCI | 63 | 2 | 0 |
| Saphir | SCE | 21 | 9 | 0 |
| Zircone blanche | SCI | 58 | 14 | -1 |
| Zircone blanche | SCE | 24 | 38 | 17 |

Lorsque le matériau constituant le substrat 11 est du saphir, le revêtement 12 peut être observé de façon directe, c'est-à-dire qu'il est agencé entre un observateur et le substrat 11, ou de façon indirecte, c'est-à-dire que le substrat 11 est agencé entre l'observateur et le revêtement 12, et donc que ce dernier est observé à travers le substrat 11. Il est à noter que dans le cas d'une application de l'invention dans laquelle le revêtement 12 est observé de manière indirecte, la pièce d'habillage 10 ne comporte pas de couche d'accroche 13 afin qu'elle ne dégrade pas la perception de la couleur du revêtement 12.

Le tableau ci-dessus indique les coordonnées de la couleur du revêtement 12 en observation directe, et le tableau ci-dessous indique les coordonnées de la couleur du revêtement 12 en observation indirecte.

| Matériau du substrat | SCI/SCE | L* | a* | b* |
|---|---|---|---|---|
| Saphir | SCI | 49 | 11 | -3 |
| Saphir | SCE | 15 | 34 | 21 |

La couleur rouge vif du revêtement 12 déposé sur un substrat 11 en saphir peut être caractérisée par les valeurs L* = 42, a* = 58 et b* = 72, obtenues lors de mesures de colorimétrie en mode transmission de l'illuminant normalisé D65, avec un observateur à 10° et une géométrie de mesure d:0°. Préférentiellement, il est recherché d'obtenir une couleur rouge dont les coordonnées a* et b* sont supérieures à 20, préférentiellement supérieures à 50. Plus particulièrement, il est recherché d'obtenir une couleur rouge dont les coordonnées sont L* = [30 ; 50], a* = [50 ; 70] et b* = [60 ; 80].

Dans d'autres exemples de réalisation de l'invention, le revêtement 12 peut être formé par une composition du type AB(O,N) avec A un élément métallique et B du tantale Ta. Cette caractéristique permet de choisir des oxynitrures métalliques de couleurs différentes, de sorte que le revêtement 12 puisse présenter une grande variété de couleurs.

Dans des exemples, l'élément métallique A est choisi parmi Ba, Ca, Nd, La, Sr, Eu, Yb. Le revêtement 12 peut donc être formé de sorte à avoir une composition sensiblement proche ou égale à BaTaO₂N présentant une couleur rouge foncé ou brune, CaTaO₂N présentant une couleur verte ou jaune, NdTaO₂N présentant une couleur rouge ou brune, SrTaO₂N présentant une couleur orange, LaTaO₂N présentant une couleur rouge ou orange, EuTaO₂N présentant une couleur brune ou Yb₂Ta₂O₅N₂ présentant une couleur verte.

L'invention concerne en outre un procédé de fabrication d'une pièce d'habillage 10 d'horlogerie ou de bijouterie, par exemple telle que décrite ci-dessus.

Le procédé comporte une étape de dépôt d'une couche mince comprenant un oxyde métallique sur le substrat 11 de sorte que la couche mince présente une épaisseur choisie entre 300 nm et 10 µm. Cette étape de dépôt est suivie d'une étape de nitruration de la couche mince afin de former le revêtement 12 de nitrure ou d'oxynitrure métallique.

Préférentiellement, la couche mince déposée est en TaOₓ. En particulier, dans cet exemple préféré, l'étape de dépôt est réalisée par la mise en oeuvre d'une méthode de dépôt PVD en utilisant une cible en tantale Ta et un gaz réactif constitué d'O₂. En particulier, la couche mince peut être déposée par pulvérisation cathodique, par évaporation par faisceau d'électrons en phase vapeur, ou par arc, ou par ablation par faisceau laser pulsé.

A l'issue de l'étape de dépôt, la couche mince déposée est donc en TaOₓ et l'étape de nitruration est réalisée de sorte que le revêtement 12 soit réalisé en Ta₃N₅ rouge.

En particulier, l'étape de nitruration consiste à exposer la couche mince à une atmosphère appropriée, par exemple résultant d'un craquage thermique d'ammoniac, dans l'enceinte d'un four chauffé à plusieurs centaines de degrés Celsius pendant plusieurs heures. Plus précisément, l'étape de nitruration est réalisée à une température comprise entre 600°C et 1200°C durant 10h à 60h, et préférentiellement entre 700°C et 1000°C durant 20h à 50h. Dans l'exemple de mise en oeuvre le plus préféré, l'étape de nitruration est réalisée à une température de 900°C durant 40h. A titre d'exemple, lors de l'étape de nitruration, le débit d'ammoniac craqué dans l'enceinte du four est de 200 ml/min.

Dans une variante de mise en oeuvre du procédé, la nitruration de la couche déposée n'est pas complète afin de générer un oxynitrure du matériau du revêtement 12.

Il est également envisageable, lors de l'étape de dépôt de couche mince, de déposer une couche mince à partir de plusieurs sources métalliques différentes ou d'une source métallique alliée de sorte qu'à l'issue de l'étape de nitruration, le revêtement 12 comprenne une composition du type AB(O,N) avec A un élément métallique et B du tantale Ta.

Le procédé de fabrication peut avantageusement comprendre une étape de dépôt d'une couche d'accroche 13 telle que décrite ci-dessus, avant la réalisation de l'étape de dépôt du revêtement 12, par exemple par une méthode de dépôt CVD, ALD ou PVD. Avantageusement, l'étape de dépôt de la couche d'accroche 13 et l'étape de dépôt du revêtement 12 peuvent être réalisées successivement, dans une même enceinte de dépôt, la pression dans ladite enceinte étant conservée entre les deux dépôts. Ces étapes de dépôt requièrent au moins deux sources de matériaux différents, dont une est destinée à être utilisée pour former la couche d'accroche 13 sur le substrat 11 et une est destinée à être utilisée pour former le revêtement 12 sur la couche d'accroche 13.

De manière plus générale, il est à noter que les modes de mise en oeuvre et de réalisation considérés ci-dessus ont été décrits à titre d'exemples non limitatifs, et que d'autres variantes sont par conséquent envisageables.

Notamment, il est envisageable de réaliser une étape de structuration sélective de la couche mince sur la totalité de son épaisseur avant ou après l'étape de nitruration pour former un décor spécifique. Une telle étape peut être mise en oeuvre par des méthodes de photolithographie, par ablation laser, etc.

Dans le même objectif, il est également envisageable, de réaliser une étape préliminaire de structuration de la surface du substrat 11.

## Revendications

1. Pièce d'habillage (10) d'horlogerie ou de bijouterie **caractérisée en ce qu'**elle comprend un substrat (11) sur une surface duquel s'étend un revêtement (12) comprenant un nitrure ou oxynitrure à base de tantale Ta présentant une épaisseur comprise entre 300 nm et 10 µm, de sorte à présenter une couleur prédéterminée.

2. Pièce d'habillage (10) selon la revendication 1, dans laquelle le revêtement (12) présente une épaisseur comprise entre 1 µm et 3 µm.

3. Pièce d'habillage (10) selon la revendication 2, dans laquelle le revêtement (12) présente une épaisseur égale à 2 µm.

4. Pièce d'habillage (10) selon l'une des revendications 1 à 3, dans laquelle le revêtement (12) est réalisé en nitrure de tantale, avec une stoechiométrie sensiblement proche de ou égale à Ta3N5 orthorhombique.

5. Pièce d'habillage (10) selon l'une des revendications 1 à 4, dans laquelle le revêtement est réalisé avec un rajout d'oxygène dans la gamme de 0-5% atomiques.

6. Pièce d'habillage (10) selon l'une des revendications 1 à 5, dans laquelle le revêtement (12) présente une couleur rouge **caractérisée par** des coordonnées a* et b* supérieures à 20, préférentiellement supérieures à 50, dans l'espace colorimétrique CieLAB en mode transmission de l'illuminant normalisé D65, avec un observateur à 10° et une géométrie de mesure d:0°.

7. Pièce d'habillage (10) selon la revendication 6, dans laquelle le revêtement (12) présente une couleur rouge **caractérisée par** des coordonnées L* = [30 ; 50], a* = [50 ; 70] et b* = [60 ; 80], dans l'espace colorimétrique CieLAB en mode transmission de l'illuminant normalisé D65, avec un observateur à 10° et une géométrie de mesure d:0°.

8. Pièce d'habillage (10) selon la revendication 7, dans laquelle le revêtement (12) présente une couleur rouge **caractérisée par** des coordonnées L* = 42, a* = 58 et b* = 72, dans l'espace colorimétrique CieLAB en mode transmission de l'illuminant normalisé D65, avec un observateur à 10° et une géométrie de mesure d:0°.

9. Pièce d'habillage (10) selon l'une des revendications 1 à 5, dans laquelle le revêtement (12) forme une composition de type AB(O,N), avec B étant du tantale Ta et A un élément métallique choisi parmi Ba, Ca, Nd, La, Sr, Eu, Yb.

10. Pièce d'habillage (10) selon la revendication 9, dans laquelle le revêtement (12) est réalisé en BaTaO₂N, CaTaO₂N, NdTaO₂N, LaTaO₂N, SrTaO₂N, EuTaO₂N ou Yb₂Ta₂O₅N₂.

11. Procédé de fabrication d'une pièce d'habillage (10) d'horlogerie ou de bijouterie comprenant les étapes de :
- dépôt d'une couche mince d'un oxyde métallique à base de tantale Ta sur un substrat (11), ladite couche mince étant d'une épaisseur comprise entre 300 nm et 10 µm,
- nitruration de la couche mince de sorte à former un revêtement (12) comprenant au moins un nitrure ou oxynitrure métallique.

12. Procédé de fabrication selon la revendication 11, dans lequel lors de l'étape de dépôt, la couche mince déposée est en TaOₓ et l'étape de nitruration est réalisée de sorte que le revêtement (12) soit en nitrure de tantale, avec une stoechiométrie sensiblement proche de ou égale à Ta₃N₅ orthorhombique.

13. Procédé de fabrication selon la revendication 11, dans lequel lors de l'étape de dépôt, la couche mince déposée est en TaOₓ et est combiné avec au moins un élément métallique choisi parmi Ba, Sr, Ca, Nd, La, Eu ou Yb.

14. Procédé de fabrication selon l'une des revendications 11 à 13, dans lequel l'étape de nitruration est réalisée à une température comprise entre 600°C et 1200°C durant 10h à 60 h, préférentiellement entre 700°C et 1000°C durant 20h à 50 h.

15. Procédé de fabrication selon la revendication 14, dans lequel l'étape de nitruration est réalisée à une température de 900°C durant 40 h.
